# EUROPEAN PATENT SPECIFICATION

(11) **EP 4 413 488 B1**
(45) Date of publication and mention of the grant of the patent: **11.03.2026**
(21) Application number: 22879264.4
(22) Date of filing: 06.10.2022
(51) Int. Cl.: G06F 30/27, G06F 30/13, G06F 30/12, G06F 16/31, G06F 16/33, G06V 10/10, G06V 30/10, E21B 43/14, G06N 3/08, E21B 41/00, G06N 3/0464, G06N 5/01, G06N 20/20

(54) **WELL COMPLETION SELECTION AND DESIGN USING DATA INSIGHTS**
BOHRLOCHABSCHLUSSAUSWAHL UND -ENTWURF UNTER VERWENDUNG VON DATENEINSICHTEN
SÉLECTION ET CONCEPTION DE COMPLÉTION DE PUITS AU MOYEN D'APERÇUS DE DONNÉES

(30) Priority: 06.10.2021 US 202163262165 P
(43) Date of publication of application: 14.08.2024
(73) Proprietor: Services Pétroliers Schlumberger, 75007 Paris (FR); GeoQuest Systems B.V., 2514 JG The Hague (NL)
(72) Inventor: NAGOOR, Preetam, Houston, Texas 77077 (US); UMATE, Piyush, Houston, Texas 77056 (US); WORTHINGTON, Matthew, Houston, Texas 77056 (US); AJAYI, Oluwasefunmi, Houston, Texas 77077 (US); LYNCH, Irving, Houston, Texas 77077 (US); MASSONI ABINADER, Antonio, Houston, Texas 77056 (US)
(74) Representative: Schlumberger Intellectual Property Department
(86) International application number: PCT/US2022/045840
(87) International publication number: WO 2023/059759

(56) References cited:
- KR-A- 20110 034 743
- US-A1- 2008 289 877
- US-A1- 2011 255 794
- US-A1- 2012 054 270
- US-A1- 2014 067 353
- US-A1- 2016 335 345
- US-A1- 2017 364 795
- US-B1- 10 565 663

## Description

### CROSS-REFERENCE TO RELATED APPLICATION(S)

The subject disclosure claims priority from U.S. Provisional Appl. No. 63/262,165, filed on October 6, 2021.

### FIELD

The subject disclosure relates to planning and designing well completions using insights from historical data.

### BACKGROUND

A well completion includes equipment and associated tasks necessary to bring a wellbore into production once drilling operations have concluded, including but not limited to the assembly of downhole tubulars and equipment required to enable safe and efficient production of hydrocarbons from an oil and/or gas well. A well completion is a fundamental part of any hydrocarbon field development project. There are many different types of well completions, including but not limited to, openhole completions, cased-hole completions, slotted liner completions, screen and liner completions, cemented liner completions, and perforated casing completions.

On average 50,000 wells are drilled annually and an estimated 2 million are currently active globally. Every single one of these wells requires completion equipment, and each piece of equipment is selected to address a key purpose. A typical well completion may include a safety valve normally used for emergency shut down, downhole gauges to measure pressure and temperature, packers to isolate formation or divert flow, flow control valves to control flow from each zone and screens for sand control. With each piece of equipment having thousands of possible variations to address size (inner and outer diameter), metallurgy and pressure/temperature requirements, the tasks of selecting completion equipment and designing a well completion are daunting. All this information is stored in multiple documents or files of various formats.

Well completion design involves the selection of various equipment types to meet the production goals based on various sizes and metallurgical requirements, design constraints like pressure, temperature and fluids, equipment deployment considerations like single trip or multi-trip as well as the need to ensure reliability of downhole equipment.

Well completion design is a cross domain collaborative process between reservoir engineers, production engineers, drilling, and completion engineers. Inputs from various domains are gathered for a successful well completion design. The initial requirement starts from the reservoir domain determining formation types, type of fluids to be produced, trends of reservoir pressure and drawdowns over the life of the well. The production domain then plans well types, tubing sizes, zones to be perforated, nodal analysis, and surface handling restrictions. The requirements are then passed to the drilling domain for well construction planning and rig requirements. Finally, the completion engineer consolidates all the requirements from each individual department and selects the appropriate equipment to deliver a well completion design which meets constraints like pressure and temperature. Other factors that will be taken into consideration include: (a) evaluating construction/deployment of the well completion in single or multiple trips; (b) considering operational safety during construction/deployment; and (c) reliability and economics.

Current processes for well completion design involve email and document exchange between engineers while gathering data from various sources to plan a well completion. The workflow goes back and forth between domains through exchanges of emails and documents in a very inefficient way. Having to manually select from thousands of equipment variations based on local knowledge may lead to sub-optimal design. Further, the entire process can take months for a team to finalize a well completion design. In this manner, the current well completion design process is inefficient and not scalable.

Furthermore, historical data that characteries the planning, design, or construction/deployment of prior well completions as well as operation or performance of the resulting wells can provide insights to help simplify or otherwise improve the well completion design process. However, locating and accessing such historical data is a cumbersome task, typically requiring manual steps to research and find historical data that is relevant to the particular hydrocarbon field development project. US 10565663 B1 discloses a method for analyzing resource production. US 2017/0364795 A1 discloses a petroleum analytics learning machine system. US 2014/067353 A1 discloses a wellbore completion and hydraulic fracturing optimization method.

### SUMMARY

This summary is provided to introduce a selection of concepts that are further described below in the detailed description. This summary is not intended to identify key or essential features of the claimed subject matter, nor is it intended to be used as an aid in limiting the scope of the claimed subject matter.

The present disclosure describes methods and systems for well completion selection and design that use machine learning and natural language processing.

A method according to claim 1 is disclosed.

In embodiments, the graphical user interface can be generated by using association between the structured data and the well contexts to identify and retrieve from the database structured data that corresponds to a particular well context of interest and provide for at least one relevant insight based on the retrieved structured data.

In embodiments, the particular well context of interest can relate to a particular standard completion design contemplated for use by a user.

In embodiments, the at least one relevant insight can include at least one of environmental conditions, geological conditions, operational conditions, and historical failure information.

In embodiments, at least one relevant insight can relate to reliability, record tracking, string complexity, cost, ease of installation, maturity, and combinations thereof.

In embodiments, the plurality of unstructured schematic documents related to prior well completions can be identified or filtered from the historical dataset by operations that group the unstructured documents of the historical dataset into a plurality of clusters. For example, the operations can employ an unsupervised clustering method.

In embodiments, the plurality of unstructured schematic documents related to prior well completions can be identified or filtered from the historical dataset by operations that employ an ensemble of machine learning systems configured to classify a given unstructured document into one of a predefined plurality of classes that include a class corresponding to unstructured schematic documents and a class corresponding to non-unstructured schematic documents.

In embodiments, the ensemble of machine learning systems can include at least one machine learning system configured to classify the given unstructured document based on textual features of the given unstructured document and at least one machine learning system configured to classify the given unstructured document based on visual features of the given unstructured document.

In embodiments, the ensemble of machine learning systems can include at least one of a random forest machine learning system and a convolutional neural network machine learning system.

In embodiments, the processing of a given unstructured schematic document can include operations that convert a given unstructured document assigned to the class corresponding to unstructured schematic documents to a converted schematic document of a predefined type. For example, the predefined type can be a Microsoft Excel document. In embodiments, the operations can include i) first operations that apply computer vision edge-detection and/or contour-finding techniques to the given unstructured document to generate a table skeleton layout, ii) second operations that apply optical character recognition (OCR) to bounding boxes derived from the table skeleton layout; and iii) third operations that merge the table skeleton layout and OCR results to generate the converted schematic document.

In embodiments, the processing of a given unstructured schematic document can employ a natural language processing engine together with a domain dictionary to generate structured data based on text of the converted schematic document.

In embodiments, the domain dictionary can include words and phrases used in the design, planning, and construction of well completions as well as the operation and performance of resulting wells.

In embodiments, the domain dictionary can be built with the help of domain experts to aid in various processing tasks that translate to text the converted schematic document into a structured format and generate the structured data in electronic form.

In embodiments, the natural language processing engine can be configured to perform at least one processing task on text of the converted schematic document, wherein the at least one processing task is selected from the group consisting of text segmentation, part-of-speech tagging, text classification, keyword, concept extraction, and combinations thereof.

In embodiments, associations between structured data corresponding to text of the respective unstructured schematic documents and different well contexts are derived from a multi-level clustering method.

In embodiments, systems are provided for designing a well completion which employ at least one data processor. In embodiments, the at least one data processor can employ computing resources that are part of a cloud computing environment.

### BRIEF DESCRIPTION OF THE DRAWINGS

The subject disclosure is further described in the detailed description which follows, in reference to the noted plurality of drawings by way of non-limiting examples of the subject disclosure, in which like reference numerals represent similar parts throughout the several views of the drawings, and wherein:
FIG. 1 is a schematic diagram of a workflow management system according to an embodiment of the subject disclosure;
FIGS. 2A- 2C, collectively, is a flowchart of a data processing workflow that can be embodied by the workflow management system of FIG. 1 in accordance with an embodiment of the subject disclosure;
FIG. 3 is a schematic diagram of a data processing workflow that can be embodied by the workflow management system of FIG. 1 in accordance with an embodiment of the subject disclosure; and
FIG. 4 is a schematic diagram of a computer system.

### DETAILED DESCRIPTION

The particulars shown herein are by way of example and for purposes of illustrative discussion of the embodiments of the subject disclosure only and are presented in the cause of providing what is believed to be the most useful and readily understood description of the principles and conceptual aspects of the subject disclosure. In this regard, no attempt is made to show structural details in more detail than is necessary for the fundamental understanding of the subject disclosure, the description taken with the drawings making apparent to those skilled in the art how the several forms of the subject disclosure may be embodied in practice. Furthermore, like reference numbers and designations in the various drawings indicate like elements.

It is to be understood that the present disclosure provides many different embodiments, or examples, for implementing different features of various embodiments. Specific examples of components and arrangements are described below to simplify the present disclosure. These are, of course, merely examples and are not intended to be limiting.

The term "document" as used herein is a specific type of file produced or edited by a specific application and usually capable of being printed.

The term "unstructured data" as used herein is electronic information that is not arranged according to a preset data model or schema, and therefore cannot be efficiently stored in a traditional relational database or relational database management system.

The term "structured data" as used herein is electronic information that is arranged according to a preset data model or schema, and therefore can be efficiently stored in a traditional relational database or relational database management system.

The term "unstructured document" as used herein is a document that contains unstructured data. For example, an unstructured document can include a pdf document, an image, a Word document or Pages document or other word-processing document, a PowerPoint document or Keynote document or other presentation document, or a Microsoft Excel document or Numbers document or other spreadsheet document.

The term "unstructured schematic document" as used herein is an unstructured document that contains unstructured data in tabular form (e.g., where the unstructured data is arranged in rows and columns).

The term "unstructured non-schematic document" as used herein is an unstructured document that is not containing unstructured data in tabular form (e.g., where the unstructured data is arranged in rows and columns).

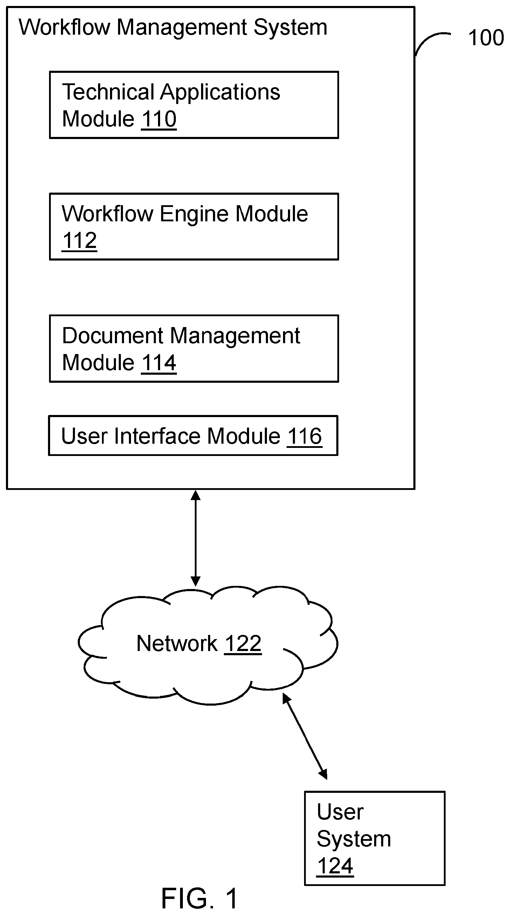

FIG. 1 shows a block diagram of a workflow management system 100 according to an embodiment of the subject disclosure. As will be described herein, workflow management system 100 integrates well planning workflows with industry standard technical applications (e.g., engineering modeling applications); provides audit trails of events as well completions are planned or altered; allows authorized personnel to approve well completion designs and construction/deployment tasks; and integrates document management systems to provide best practice documentation and related data at any point along the workflow. In addition, workflow management system 100 integrates historical data for use in driving and understanding the planning and design and of well completions.

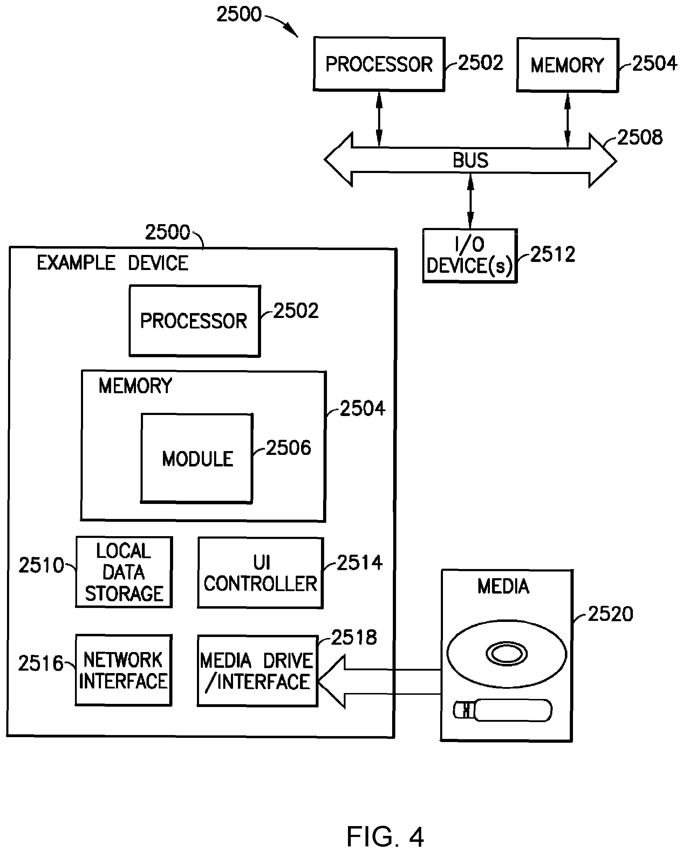

In an embodiment, the workflow management system 100 includes a technical applications module 110, a workflow engine module 112, a document management module 114, and a user interface module 116. Although not shown, the workflow management system 100 includes at least one processor (e.g., FIG. 4) configured to implement the operations described herein, and may further include a non-transitory, computer-readable storage and transceiver/network communication module, all interconnected via a system bus, as would be understood by those ordinarily skilled in the art having the benefit of this disclosure. Moreover, the workflow management system 100 can be implemented by software instructions executable by the processor for implementing the operations described herein. The software instructions may be stored on the storage device or some other computer-readable medium.

In embodiments, the technical applications module 110 can embody a set of engineering tools for planning and designing well completions and possibly for optimizing well operations. Such engineering tools can provide detailed operations and tools useful in the engineering of well completions from prototype to design to deployment/construction of well completions and possibly for related well operations. The workflow engine module 112 executes one or more workflow processes that provide for the planning, design, and deployment/construction of well completions and/or related workflow processes. The document management module 114 provides the ability to integrate documentation into workflow management system 100 such as, for example, best practice documentation or technical journals relevant to the workflow. A variety of document management applications may be embodied in document management module 114 such as, for example, SharePoint^{®} or other similar platforms that provide document and file management, system and process integration, workflow automation, etc. The workflow engine module 112 can cooperate with the technical applications module 110 and/or the document management module 114 via data communication in conjunction with the workflow processes executed by the workflow engine module 112. The user interface module 116 provides a user interface for access to the workflows provided by the workflow engine module 112, the documents managed by the document management module 114, and/or the engineering tools provided by the technical applications module 110.

The workflow management system 100 can further include additional functionality that supports the operation of the system. For example, such additional functionality can include web application logic, one or more relational database management systems, user authorization logic and other security features, networking functionality, as well as other operating system and middleware software components.

In embodiments, the workflow management system 100 can be embodied by a cloud computing environment. The cloud computing environment can provide on-demand or managed computer system resources, such as data storage (cloud storage) and computing power. The computer system resources can possibly be distributed over multiple geographic locations to minimize latency and provide resiliency in case of network failure.

The workflow management system 100 is operably coupled to one or more public and/or private networks 122 via appropriate network connection. As understood in the art, such network connections may include wired or wireless networks such as, for example, a wide area network, virtual private network, or enterprise private network.

End user systems 124 communicate with the workflow management system 100 via any appropriate network connection as shown. End user systems 124 comprise all necessary hardware, software, local area networking capability, etc., to facilitate end user interaction with workflow management application 100 via the user interface module 116. In embodiments, the end user systems 124 can include desktop computers, workstations, laptops or notebook computer systems, mobile devices such as smartphone and tablet computers, or other suitable networked computing devices.

Embodiments of the subject disclosure may be generally used in conjunction with a hydrocarbon field development project that includes one or more reservoirs and prospective wells that will be constructed to produce hydrocarbons from the reservoir(s). The wells may include, without limitation, completions and associated devices, such as production tubing, sensors, packers, inflow control devices, and artificial lift equipment such as electrical submersible pumps, progressive cavity pumps, and sucker rod pumps.

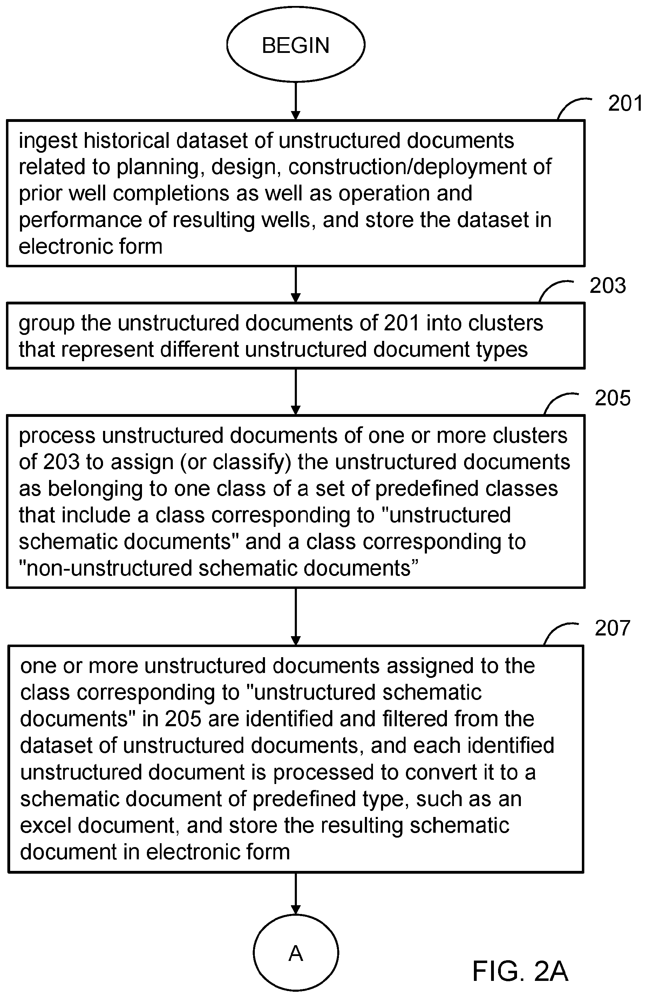

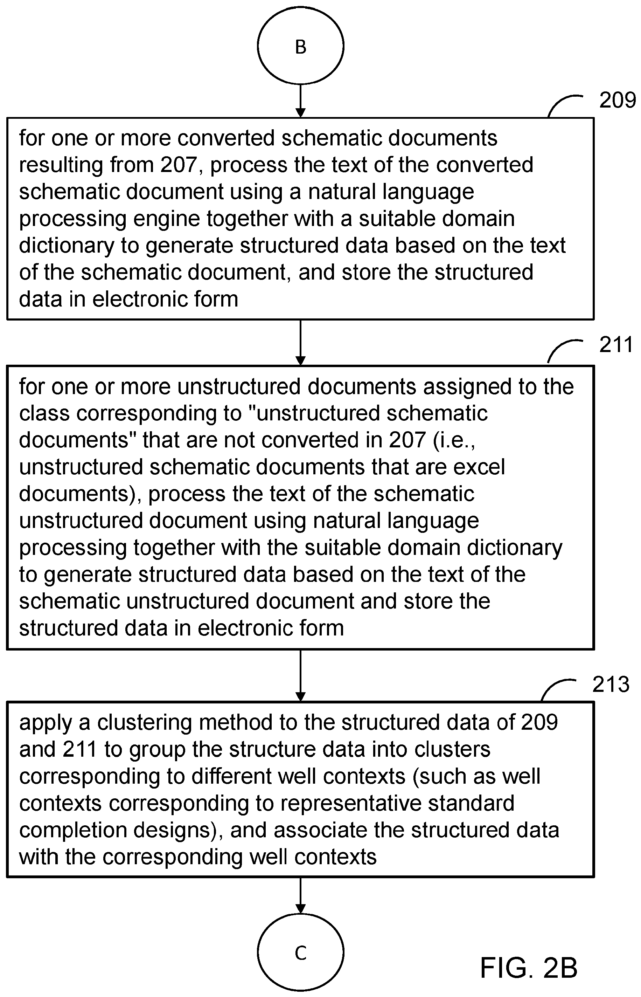

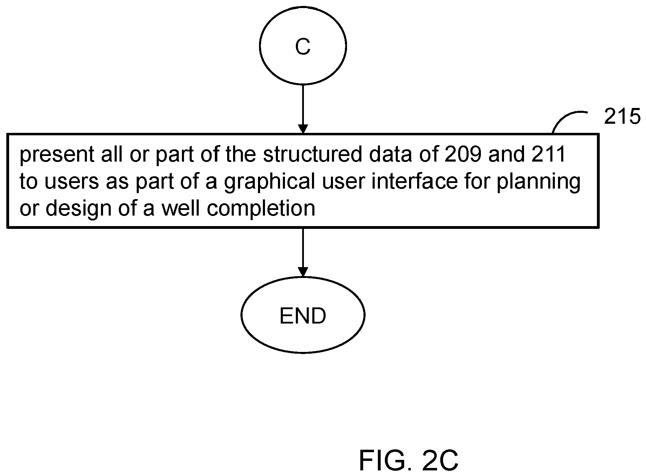

FIGS. 2A - 2C, collectively, depict a workflow of the operations that can be carried out by the workflow management system 100 of FIG. 1 or possibly on some other computer system (e.g., FIG. 4).

The operations begin in block 201 by ingesting or collecting an historical dataset of unstructured documents related to planning, design, and/or construction/deployment of prior well completions and as well as to operation and performance (e.g., failure information) of the resultant wells. The historical dataset can be collected from operating companies and/or service companies that are involved in these tasks. The historical dataset can be stored in electronic form for subsequent use.

In block 203, the unstructured documents of the historical dataset of 201 are grouped into clusters that represent different unstructured document types. These document types might be, but are not limited to, Microsoft Excel, Microsoft Word, Portable Document Format (PDF), Joint Photographic Experts Group (JPEG) and Portable Network Graphics (PNG). The clustering leverages the underlying data structure of the documents in order to perform these groupings. Each cluster from block 203 represents unstructured data of a particular file type. Each file type requires its own custom processing in order to classify the document as belonging to a particular class.

In block 205, the unstructured documents in one or more of the clusters of 203 are processed to classify the unstructured documents as belonging to one class of a set of predefined classes that include a class corresponding to "unstructured schematic documents" and a class corresponding to "non-unstructured schematic documents." In embodiments, the processing can involve extracting textual features and visual features of a given unstructured document, inputting textual feature data representing the extracted textual features to one or more machine learning models that is (are) trained to output data related to the set of predefined classes (e.g., data representing a probability that the given unstructured document belongs to each class of the set of predefined classes), inputting visual feature data representing the extracted visual features to one or more machine learning models that is trained to output data related to the set of predefined classes (e.g., data representing a probability that the given unstructured document belongs to each class of the set of predefined classes), and evaluating the data output by the ensemble of machine learning models to assign one class of the set of predefined classes to the given unstructured document. The ensemble of machine learning models can be trained by supervised learning using labeled training data. For example, the labeled training data can include textual feature data from unstructured documents with corresponding labels (e.g., data representing desired probabilities for each class of the set of predefined classes) and visual feature data from unstructured documents with corresponding labels (e.g., data representing desired probabilities for each class of the set of predefined classes). The labeled training data can be selected to enable the ensemble of machine learning models to accurately predict the probabilities for each class of the set of predefined classes given textual feature data and visual feature data extracted from a new unstructured document, and thus enable evaluation of such probabilities to assign one class from the set of predefined classes to the new unstructured document. In this manner, the output of the ensemble of machine learning models can be trained and used to selectively classify certain unstructured documents as "unstructured schematic documents " and other unstructured documents as "non-unstructured schematic documents." In embodiments, the ensemble of machine learning networks can include one or more random forest networks and/or one or more convolutional neural networks (such as the Inception-v3 convolutional neural network). The random forest network employs an ensemble learning method for text-based classification by constructing a multitude of decision trees at training time. For classification tasks, the output of the random forest network can be class selected by most decision trees. The convolutional neural network generally includes an input layer, hidden layers, and an output layer, all configured to perform image-based classification. The hidden layers include layers that perform convolutions. Typically this includes a layer that performs a dot product of the convolution kernel with the layer's input matrix. This product is usually the Frobenius inner product, and its activation function is commonly ReLU. As the convolution kernel slides along the input matrix for the layer, the convolution operation generates a feature map, which in turn contributes to the input of the next layer. This is followed by other layers such as pooling layers, fully connected layers, and normalization layers.

In block 207, one or more unstructured documents assigned to the class corresponding to "unstructured schematic documents" in 205 are identified and filtered from the dataset of unstructured documents, and each identified unstructured document is processed to convert it to a schematic document of a predefined type, such as a Microsoft Excel document, and the resulting schematic document is stored in electronic form. The resulting schematic document is referred to herein as a "converted schematic document." In embodiments, such processing can apply computer vision edge-detection and/or contour-finding techniques to the given unstructured document to generate a table skeleton layout. Optical character recognition (OCR) can be applied to bounding boxes derived from the table skeleton layout. The table skeleton layout and the OCR results can be merged to generate the converted schematic document. In embodiments, such processing can be performed on all unstructured documents assigned to the class corresponding to "unstructured schematic documents" that do not correspond to the predefined type (i.e., unstructured schematic documents that are not Microsoft Excel documents).

In block 209, for one or more converted schematic documents of 207, the text of the converted schematic document can be processed using a natural language processing engine together with a suitable domain dictionary to generate structured data based on the text of the converted schematic document and store the structured data in electronic form. In this case, the domain dictionary can include words and phrases used in the design, planning, and construction of well completions as well as the operation and performance of resulting wells. The natural language processing engine can perform various processing tasks on the text of the converted schematic document. For example, such processing tasks can include: text segmentation, part-of-speech tagging, text classification, keyword and concept extraction, etc., or combinations thereof. The domain dictionary can be a data dictionary built with the help of domain experts to aid in the various processing tasks that translate to text of the converted schematic document into a structured format and generate the structured data in electronic form.

In block 211, for one or more unstructured documents assigned to the class corresponding to "unstructured schematic documents" that are not converted in 207 (i.e., unstructured schematic documents that are Microsoft Excel documents), the text of the unstructured schematic document can be processed using natural language processing together with the suitable domain dictionary to generate structured data based on the text of the unstructured schematic document, and the structured data can be stored in electronic form. Similar to block 209, the natural language processing engine can perform various processing tasks on the text of the unstructured schematic document. For example, such processing tasks can include: text segmentation, part-of-speech tagging, text classification, keyword and concept extraction, etc., or combinations thereof. The domain dictionary can be a data dictionary built with the help of domain experts to aid in the various processing tasks that translate to text of the unstructured schematic document into a structured format and generate the structured data in electronic form.

In block 213, a clustering method can be applied to the structured data of 209 and 211 to group the structured data into clusters corresponding to different well contexts, such as representative standard completion designs, and the structured data can be associated with the corresponding well context metadata. For example, the structured data and the corresponding well context meta-data can be stored as records in one or more tables of a relational database that are linked or otherwise associated with one another. The clustering of 213 can employ multi-level clustering that considered different well completion equipment, different well completion types, and different environmental (e.g., pressure and temperature) conditions.

In block 215, all or part of the structured data of 209 and 211 can be presented to users as part of a graphical user interface for well completion design. For example, the graphical user interface can be provided by the user interface module 116 for a workflow executed by the workflow engine 112 of FIG. 1. In embodiments, the graphical user interface can generate well completion design recommendations and insights. The association between the structured data and the well contexts as provided in 213 can be used to identify and retrieve structured data that corresponds to a particular well context of interest (e.g., a particular standard completion design contemplated for use by a user) and provide for relevant insights based on the retrieved structured data, such as environmental, geological, and operational conditions as well as historical failure information. The relevant insights can relate to reliability, record tracking, string complexity, cost, ease of installation and maturity. Optimal well completion design architectures and equipment can then be determined.

In embodiments, users can select standardized completion design for completing a well and access historical data related to the selected standardized completion design to extract relevant insights that can inform decision making, improve operations and generate value.

In embodiments, the system enables users to gain valuable insights and information from unstructured documents which have been accumulated over several decades. The system can leverage a highly representative historical dataset of different completion designs and schematics.

In embodiments, the system can reuse the analytics blocks trained on the historical dataset to ingest unstructured data, transform the unstructured data into a structured format, and provide valuable insights and recommendations based thereon.

In embodiments, the historical dataset can include information relating to wells, well components and completions equipment used on the wells and failure information relating to these wells and the completions equipment. The system can be configured to ingest this information in the form of Microsoft Excel documents, Pdf documents and other image formats.

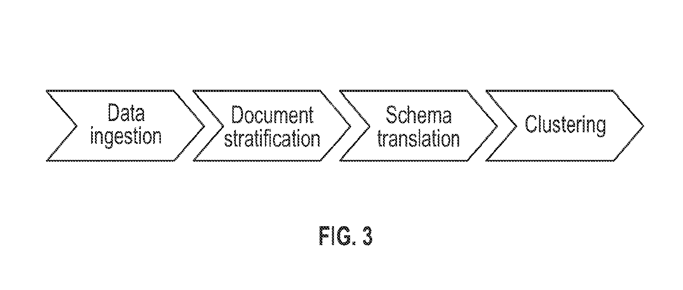

FIG. 3 depicts an embodiment of the subject disclosure comprising four primary modules or stages. The first module or stage involves ingestion of an historical dataset of unstructured documents. The next module or stage relates to stratification which involves figuring out which unstructured documents are of interest (e.g., unstructured schematic documents). In embodiments, the stratification module can be configured to group the historical dataset of unstructured documents into clusters that represent different unstructured document types. The unstructured documents in one or more of the clusters can be processed by an ensemble of machine learning models (e.g., random forest and convolutional neural networks) that perform text-based classification and image-based classification, respectively, to identify and filter out unstructured schematic documents from the historical dataset. After filtering out the unstructured schematic documents , the unstructured schematic documents are passed to the schema translation module, which extracts and processes the textual data of the unstructured schematic documents from the unstructured to a structured data space so that it is easy to analyze the historical data and gain valuable information therefrom. The schema translation module can employ computer vision techniques such as edge detection and contour finding algorithms to create a table skeleton layout of unstructured schematic document, and employ OCR to extract text from bounding boxes within the unstructured schematic document. A merging algorithm can be used to combine the table skeleton layout and the OCR results to generate a corresponding converted unstructured document (for example, with a predefined Microsoft Excel format). The converted unstructured documents and other unstructured schematic documents of the same type (i.e., in Microsoft Excel format) can be processed by a domain dictionary powered natural language processing engine to transform the text data of the unstructured documents to a structured schema. Finally, the clustering module groups the resulting structured data based on different well contexts and representative standard well completion designs.

In embodiments, these standardized well completion designs and insights can be provided to a user via a user interface. The machine learning pipeline can be configured to extract valuable information from the thousands of unstructured documents (such as Pdf documents and Microsoft Excel completion design documents accumulated over a large time period, such as the past several decades), and this historical knowledge can be stored in an intelligent database which can then be used by completion engineers to make the right completion design architecture selection for a specific well context.

For example, a flexible rules engine (e.g., part of workflow engine module 112 of FIG. 1) can enable engineers to specify constraints like pressure, temperature and specific well production challenges relating to reservoir condition and production environment. The system can then generate well completion design recommendations and insights. This alleviates the problem of localized design based on siloed local knowledge. The insights can generate major and minor trends across the entire data set based on context and environment. Displays can include KPIs and metrics relating to the completion design. These standardized designs can be applicable globally for a given well context and environment. The user can filter a specific completion design based on a specific well context. The insights can be based on environment, geological and operational conditions coupled with historical failure information. Examples include how often a specific equipment or hardware failed in a certain well context, amount of time needed to run an equipment/hardware, equipment compatibility and cost. In addition, each design has associated KPIs, e.g., reliability, record tracking, maturity, installation, string complexity, and benefits of this completion e.g., delivers HPHT performance. This helps guide an engineer in making better design selections such as reliability, record tracking, maturity, and installation complexity. Other KPIs include installation efficiency, lead time and inventory for equipment, rig time etc.

In some embodiments, the methods and systems of the present disclosure may involve a computing system. FIG. 4 illustrates an example computing system 2500, with a processor 2502 and memory 2504 that can be configured to implement various embodiments of the subject disclosure. Memory 2504 can also host one or more databases and can include one or more forms of volatile data storage media such as random-access memory (RAM), and/or one or more forms of nonvolatile storage media (such as read-only memory (ROM), flash memory, and so forth).

Device 2500 is one example of a computing device or programmable device and is not intended to suggest any limitation as to scope of use or functionality of device 2500 and/or its possible architectures. For example, device 2500 can comprise one or more computing devices, programmable logic controllers (PLCs), etc.

Further, device 2500 should not be interpreted as having any dependency relating to one or a combination of components illustrated in device 2500. For example, device 2500 may include one or more of computers, such as a laptop computer, a desktop computer, a mainframe computer, etc., or any combination or accumulation thereof.

Device 2500 can also include a bus 2508 configured to allow various components and devices, such as processors 2502, memory 2504, and local data storage 2510, among other components, to communicate with each other.

Bus 2508 can include one or more of any of several types of bus structures, including a memory bus or memory controller, a peripheral bus, an accelerated graphics port, and a processor or local bus using any of a variety of bus architectures. Bus 2508 can also include wired and/or wireless buses.

Local data storage 2510 can include fixed media (e.g., RAM, ROM, a fixed hard drive, etc.) as well as removable media (e.g., a flash memory drive, a removable hard drive, optical disks, magnetic disks, and so forth). One or more input/output (I/O) device(s) 2512 may also communicate via a user interface (UI) controller 2514, which may connect with I/O device(s) 2512 either directly or through bus 2508.

In one possible implementation, a network interface 2516 may communicate outside of device 2500 via a connected network. A media drive/interface 2518 can accept removable tangible media 2520, such as flash drives, optical disks, removable hard drives, software products, etc. In one possible implementation, logic, computing instructions, and/or software programs comprising elements of module 2506 may reside on removable media 2520 readable by media drive/interface 2518.

In one possible embodiment, input/output device(s) 2512 can allow a user (such as a human annotator) to enter commands and information to device 2500, and also allow information to be presented to the user and/or other components or devices. Examples of input device(s) 2512 include, for example, sensors, a keyboard, a cursor control device (e.g., a mouse), a microphone, a scanner, and any other input devices known in the art. Examples of output devices include a display device (e.g., a monitor or projector), speakers, a printer, a network card, and so on.

Various systems and processes of present disclosure may be described herein in the general context of software or program modules, or the techniques and modules may be implemented in pure computing hardware. Software generally includes routines, programs, objects, components, data structures, and so forth that perform particular tasks or implement particular abstract data types. An implementation of these modules and techniques may be stored on or transmitted across some form of tangible computer-readable media. Computer-readable media can be any available data storage medium or media that is tangible and can be accessed by a computing device. Computer readable media may thus comprise computer storage media. "Computer storage media" designates tangible media, and includes volatile and nonvolatile, removable, and non-removable tangible media implemented for storage of information such as computer readable instructions, data structures, program modules, or other data. Computer storage media include, but are not limited to, RAM, ROM, EEPROM, flash memory or other memory technology, CD-ROM, digital versatile disks (DVD) or other optical storage, magnetic cassettes, magnetic tape, magnetic disk storage or other magnetic storage devices, or any other tangible medium which can be used to store the desired information, and which can be accessed by a computer.

Some of the methods and processes described above, can be performed by a processor. The term "processor" should not be construed to limit the embodiments disclosed herein to any particular device type or system. The processor may include a computer system. The computer system may also include a computer processor (e.g., a microprocessor, microcontroller, digital signal processor, general-purpose computer, special-purpose machine, virtual machine, software container, or appliance) for executing any of the methods and processes described above.

The computer system may further include a memory such as a semiconductor memory device (e.g., a RAM, ROM, PROM, EEPROM, or Flash-Programmable RAM), a magnetic memory device (e.g., a diskette or fixed disk), an optical memory device (e.g., a CD-ROM), a PC card (e.g., PCMCIA card), or other memory device.

Alternatively or additionally, the processor may include discrete electronic components coupled to a printed circuit board, integrated circuitry (e.g., Application Specific Integrated Circuits (ASIC)), and/or programmable logic devices (e.g., a Field Programmable Gate Arrays (FPGA)). Any of the methods and processes described above can be implemented using such logic devices.

Some of the methods and processes described above, can be implemented as computer program logic for use with the computer processor. The computer program logic may be embodied in various forms, including a source code form or a computer executable form. Source code may include a series of computer program instructions in a variety of programming languages (e.g., an object code, an assembly language, or a high-level language such as C, C++, or JAVA). Such computer instructions can be stored in a non-transitory computer readable medium (e.g., memory) and executed by the computer processor. The computer instructions may be distributed in any form as a removable storage medium with accompanying printed or electronic documentation (e.g., shrink wrapped software), preloaded with a computer system (e.g., on system ROM or fixed disk), or distributed from a server or electronic bulletin board over a communication system (e.g., the Internet or World Wide Web).

## Claims

1. A method for designing a well completion, wherein the method is used in conjunction with a hydrocarbon field development project that includes a reservoir and prospective wells that will be constructed to produce hydrocarbons from the reservoir, comprising:
i) collecting (201) an historical dataset comprising unstructured data related to prior well completions, comprising ingesting or collecting a historical dataset of unstructured documents related to planning, design, and/or construction/deployment of prior well completions, as well as to operation and performance of the resultant wells;
ii) identifying (203, 205, 207) a plurality of unstructured schematic documents related to prior well completions that are a part of the historical dataset of i) by grouping (203) the unstructured documents of the historical dataset into clusters that represent different unstructured document types, processing (205) the unstructured documents of one or more clusters to assign or classify the unstructured documents as belonging to one class of a set of predefined classes that include a class corresponding to unstructured schematic documents and a class corresponding to non-unstructured schematic documents and identifying (207) and filtering the one or more unstructured documents assigned to the class corresponding to unstructured schematic documents from the dataset of unstructured documents, and processing each identified unstructured document to convert the identified unstructured document to a schematic document of a predefined type;
iii) processing (209, 211) each given unstructured schematic document of the plurality of unstructured schematic documents of ii) to generate structured data corresponding to text of the given unstructured schematic document using a natural language processing engine together with a suitable domain dictionary to generate structured data based on the text of the converted schematic document and processing (211), for one or more unstructured documents assigned to the class corresponding to unstructured schematic documents that are not converted, the text of the unstructured schematic document using natural language processing together with the suitable domain dictionary to generate structured data based on the text of the unstructured schematic document;
iv) associating (213) the structured data corresponding to text of the respective unstructured schematic documents of iii) with different well contexts as part of a database by applying a clustering method to the structured data to group the structure data into clusters corresponding to different well contexts, and associating the structured data with the corresponding well contexts metadata; and
v) presenting (215) a graphical user interface to a user for designing a well completion, wherein the graphical user interface presents structured data stored in the database of iv) for insight in designing the well completion.

2. A method according to claim 1, wherein:
the graphical user interface of v) is generated (215) by using association between the structured data and the well contexts to identify and retrieve from the database structured data that corresponds to a particular well context of interest and provide for at least one relevant insight based on the retrieved structured data.

3. A method according to claim 2, wherein:
the particular well context of interest relates to a particular standard completion design contemplated for use by a user.

4. A method according to claim 2, wherein:
the at least one relevant insight includes at least one of environmental conditions, geological conditions, operational conditions, and historical failure information.

5. A method according to claim 2, wherein:
the at least one relevant insight relates to reliability, record tracking, string complexity, cost, ease of installation, maturity, and combinations thereof.

6. A method according to claim 1, wherein:
the operations employ an unsupervised clustering method.

7. A method according to claim 1, wherein:
the identifying (203, 205, 207) of ii) includes operations that employ (205) an ensemble of machine learning systems configured to classify a given unstructured document into the one of a predefined plurality of classes that include a class corresponding to unstructured schematic documents and a class corresponding to non-unstructured schematic documents.

8. A method according to claim 7, wherein:
the ensemble of machine learning systems include at least one machine learning system configured to classify the given unstructured document based on textual features of the given unstructured document and at least one machine learning system configured to classify the given unstructured document based on visual features of the given unstructured document.

9. A method according to claim 7, wherein:
the ensemble of machine learning systems comprises at least one of a random forest machine learning system and a convolutional neural network machine learning system.

10. A method according to claim 1, wherein:
the operations include i) first operations that apply computer vision edge-detection and/or contour-finding techniques to the given unstructured document to generate a table skeleton layout, ii) second operations that apply optical character recognition to bounding boxes derived from the table skeleton layout; and iii) third operations that merge the table skeleton layout and OCR results to generate the converted schematic document.

11. A method according to claim 1, wherein:
the domain dictionary is built with the help of domain experts to aid in various processing tasks that translate to text of the converted schematic document into a structured format and generate the structured data in electronic form.

12. A method according to claim 1, wherein:
the natural language processing engine is configured to perform at least one processing task on text of the converted schematic document, wherein the at least one processing task is selected from the group text segmentation, part-of-speech tagging, text classification, keyword, concept extraction, and combinations thereof.

## Patentansprüche

1. Verfahren zum Entwerfen einer Bohrlochvervollständigung, wobei das Verfahren in Verbindung mit einem Kohlenwasserstofffeldentwicklungsprojekt verwendet wird, das ein Reservoir und prospektive Bohrungen einschließt, die zur Gewinnung von Kohlenwasserstoffen aus dem Reservoir konstruiert werden, umfassend:
i) Sammeln (201) eines historischen Datensatzes, der unstrukturierte Daten in Bezug auf vorherige Bohrlochvervollständigungen, umfassend das Aufnehmen oder Sammeln eines historischen Datensatzes von unstrukturierten Dokumenten in Bezug auf Planung, Entwurf und/oder Konstruktion/Einsatz von vorherigen Bohrlochvervollständigungen sowie auf Betrieb und Leistung der resultierenden Bohrlöcher umfasst;
ii) Identifizieren (203, 205, 207) einer Vielzahl von unstrukturierten schematischen Dokumenten bezüglich vorheriger Bohrlochvervollständigungen, die ein Teil des historischen Datensatzes von i) sind, durch Gruppieren (203) der unstrukturierten Dokumente des historischen Datensatzes in Cluster, die unterschiedliche unstrukturierte Dokumenttypen darstellen, Verarbeiten (205) der unstrukturierten Dokumente eines oder mehrerer Cluster, um die unstrukturierten Dokumente als zu einer Klasse eines Satzes von vorgegebenen Klassen gehörend zuzuordnen oder zu klassifizieren, die eine Klasse entsprechend unstrukturierten schematischen Dokumenten und eine Klasse entsprechend nichtunstrukturierten schematischen Dokumenten einschließen, und Identifizieren (207) und Filtern der einen oder mehreren unstrukturierten Dokumente, die der Klasse entsprechend unstrukturierten schematischen Dokumenten zugeordnet sind, aus dem Datensatz von unstrukturierten Dokumenten, und Verarbeiten jedes identifizierten unstrukturierten Dokuments, um das identifizierte unstrukturierte Dokument in ein schematisches Dokument eines vorgegebenen Typs umzuwandeln;
iii) Verarbeiten (209, 211) jedes gegebenen unstrukturierten schematischen Dokuments der Vielzahl von unstrukturierten schematischen Dokumenten von ii), um strukturierte Daten entsprechend dem Text des gegebenen unstrukturierten schematischen Dokuments unter Verwendung einer Verarbeitungsmaschine für natürliche Sprache zusammen mit einem geeigneten Domänenwörterbuch zu erzeugen, um strukturierte Daten basierend auf dem Text des konvertierten schematischen Dokuments zu erzeugen, und Verarbeiten (211), für ein oder mehrere unstrukturierte Dokumente, die der Klasse zugeordnet sind, die unstrukturierten schematischen Dokumenten entspricht, die nicht konvertiert sind, des Texts des unstrukturierten schematischen Dokuments unter Verwendung von Verarbeitung natürlicher Sprache zusammen mit dem geeigneten Domänenwörterbuch, um strukturierte Daten basierend auf dem Text des unstrukturierten schematischen Dokuments zu erzeugen;
iv) Zuordnen (213) der strukturierten Daten, die dem Text der jeweiligen unstrukturierten schematischen Dokumente von iii) entsprechen, zu unterschiedlichen Bohrlochkontexten als Teil einer Datenbank durch Anwenden eines Clustering-Verfahrens auf die strukturierten Daten, um die Strukturdaten in Cluster zu gruppieren, die unterschiedlichen Bohrlochkontexten entsprechen, und Zuordnen der strukturierten Daten zu den entsprechenden Bohrlochkontextmetadaten; und
v) Darstellen (215) einer grafischen Benutzeroberfläche an einen Benutzer zum Entwerfen einer Bohrlochvervollständigung, wobei die grafische Benutzeroberfläche strukturierte Daten, die in der Datenbank von iv) gespeichert sind, zur Einsicht beim Entwerfen der Bohrlochvervollständigung darstellt.

2. Verfahren nach Anspruch 1, wobei:
die grafische Benutzeroberfläche von v) erzeugt wird (215), indem eine Zuordnung zwischen den strukturierten Daten und den Bohrlochkontexten verwendet wird, um strukturierte Daten, die einem besonderen Bohrlochkontext von Interesse entsprechen, aus der Datenbank zu identifizieren und abzurufen und mindestens eine relevante Erkenntnis basierend auf den abgerufenen strukturierten Daten bereitzustellen.

3. Verfahren nach Anspruch 2, wobei:
der besondere Bohrlochkontext von Interesse sich auf einen besonderen Standardvervollständigungsentwurf bezieht, der zur Verwendung durch einen Benutzer in Betracht gezogen wird.

4. Verfahren nach Anspruch 2, wobei:
die mindestens eine relevante Erkenntnis mindestens eines von Umgebungsbedingungen, geologischen Bedingungen, Betriebsbedingungen und historischen Fehlerinformationen einschließt.

5. Verfahren nach Anspruch 2, wobei:
die mindestens eine relevante Erkenntnis sich auf Zuverlässigkeit, Aufzeichnungsverfolgung, Stringkomplexität, Kosten, Installationsfreundlichkeit, Ausgereiftheit und Kombinationen davon bezieht.

6. Verfahren nach Anspruch 1, wobei:
die Vorgänge ein unüberwachtes Clustering-Verfahren einsetzen.

7. Verfahren nach Anspruch 1, wobei:
das Identifizieren (203, 205, 207) von ii) Vorgänge einschließt, die eine Gesamtheit von maschinellen Lernsystemen einsetzen (205), die konfiguriert sind, um ein gegebenes unstrukturiertes Dokument in die eine von einer vorgegebenen Vielzahl von Klassen zu klassifizieren, die eine Klasse entsprechend unstrukturierten schematischen Dokumenten und eine Klasse entsprechend nichtunstrukturierten schematischen Dokumenten einschließen.

8. Verfahren nach Anspruch 7, wobei:
die Gesamtheit von maschinellen Lernsystemen mindestens ein maschinelles Lernsystem, das konfiguriert ist, um das gegebene unstrukturierte Dokument basierend auf textuellen Merkmalen des gegebenen unstrukturierten Dokuments zu klassifizieren, und mindestens ein maschinelles Lernsystem, das konfiguriert ist, um das gegebene unstrukturierte Dokument basierend auf visuellen Merkmalen des gegebenen unstrukturierten Dokuments zu klassifizieren, einschließt.

9. Verfahren nach Anspruch 7, wobei:
die Gesamtheit von maschinellen Lernsystemen mindestens eines von einem maschinellen Random-Forest-Lernsystem und einem maschinellen Convolutional-Neural-Network-Lernsystem umfasst.

10. Verfahren nach Anspruch 1, wobei:
die Vorgänge einschließen: i) erste Vorgänge, die Computervisionskantenerkennung und/oder Konturfindungstechniken auf das gegebene unstrukturierte Dokument anwenden, um ein Tabellenrohlayout zu erzeugen, ii) zweite Vorgänge, die optische Zeichenerkennung auf Begrenzungsrahmen anwenden, die aus dem Tabellenrohlayout abgeleitet sind; und iii) dritte Vorgänge, die das Tabellenrohlayout und die OCR-Ergebnisse zusammenführen, um das konvertierte schematische Dokument zu erzeugen.

11. Verfahren nach Anspruch 1, wobei:
das Domänenwörterbuch mit Hilfe von Domänenexperten erstellt wird, um bei verschiedenen Verarbeitungsaufgaben zu helfen, die Text des konvertierten schematischen Dokuments in ein strukturiertes Format übersetzen und die strukturierten Daten in elektronischer Form erzeugen.

12. Verfahren nach Anspruch 1, wobei:
die Verarbeitungsmaschine für natürliche Sprache konfiguriert ist, um mindestens eine Verarbeitungsaufgabe an Text des konvertierten schematischen Dokuments durchzuführen, wobei die mindestens eine Verarbeitungsaufgabe aus der Gruppe Textsegmentierung, Wortartkennzeichnung, Textklassifizierung, Schlüsselwort, Konzeptextraktion und Kombinationen davon ausgewählt ist.

## Revendications

1. Procédé de conception d'un achèvement de puits, dans lequel le procédé est utilisé conjointement avec un projet de développement de gisement d'hydrocarbure qui comporte un réservoir et des puits prospectifs qui seront construits pour produire des hydrocarbures à partir du réservoir, comprenant :
i) la collecte (201) d'un ensemble de données historiques comprenant des données non structurées liées à des achèvements de puits antérieurs, comprenant l'intégration ou la collecte d'un ensemble de données historiques de documents non structurés liés à la planification, à la conception et/ou à la construction/au déploiement d'achèvements de puits antérieurs, ainsi qu'à l'exploitation et à la performance des puits résultants ;
ii) l'identification (203, 205, 207) d'une pluralité de documents schématiques non structurés liés à des achèvements de puits antérieurs qui font partie de l'ensemble de données historiques de i) en regroupant (203) les documents non structurés de l'ensemble de données historiques en groupes qui représentent différents types de documents non structurés, le traitement (205) des documents non structurés d'un ou plusieurs groupes pour attribuer ou classer les documents non structurés comme appartenant à une classe d'un ensemble de classes prédéfinies qui comportent une classe correspondant à des documents schématiques non structurés et une classe correspondant à des documents schématiques non non structurés et l'identification (207) et le filtrage de l'un ou plusieurs documents non structurés attribués à la classe correspondant à des documents schématiques non structurés à partir de l'ensemble de données de documents non structurés, et le traitement de chaque document non structuré identifié pour convertir le document non structuré identifié en un document schématique d'un type prédéfini ;
iii) le traitement (209, 211) de chaque document schématique non structuré donné de la pluralité de documents schématiques non structurés de ii) pour générer des données structurées correspondant au texte du document schématique non structuré donné à l'aide d'un moteur de traitement de langage naturel conjointement avec un dictionnaire de domaine approprié pour générer des données structurées en fonction du texte du document schématique converti et le traitement (211), pour un ou plusieurs documents non structurés attribués à la classe correspondant à des documents schématiques non structurés qui ne sont pas convertis, du texte du document schématique non structuré à l'aide du traitement de langage naturel conjointement avec le dictionnaire de domaine approprié pour générer des données structurées en fonction du texte du document schématique non structuré ;
iv) l'association (213) des données structurées correspondant à un texte des documents schématiques non structurés respectifs de iii) à différents contextes de puits en tant que partie d'une base de données en appliquant un procédé de regroupement aux données structurées pour regrouper les données de structure en groupes correspondant à différents contextes de puits, et l'association des données structurées aux métadonnées de contextes de puits correspondantes ; et
v) la présentation (215) d'une interface utilisateur graphique à un utilisateur pour la conception d'un achèvement de puits, dans laquelle l'interface utilisateur graphique présente des données structurées stockées dans la base de données de iv) pour une connaissance de la conception de l'achèvement de puits.

2. Procédé selon la revendication 1, dans lequel :
l'interface utilisateur graphique de v) est générée (215) en utilisant l'association entre les données structurées et les contextes de puits pour identifier et récupérer de la base de données des données structurées qui correspondent à un contexte de puits particulier d'intérêt et fournir au moins une connaissance pertinente en fonction des données structurées récupérées.

3. Procédé selon la revendication 2, dans lequel :
le contexte de puits particulier d'intérêt se rapporte à une conception d'achèvement standard particulière envisagée utilisable par un utilisateur.

4. Procédé selon la revendication 2, dans lequel :
l'au moins une connaissance pertinente comporte au moins l'une parmi des conditions environnementales, des conditions géologiques, des conditions opérationnelles, et des informations historiques de défaillance.

5. Procédé selon la revendication 2, dans lequel :
l'au moins une connaissance pertinente se rapporte à la fiabilité, au suivi des enregistrements, à la complexité des chaînes, au coût, à la facilité d'installation, à la maturité, et à des combinaisons de ceux-ci.

6. Procédé selon la revendication 1, dans lequel :
les opérations utilisent un procédé de regroupement non supervisé.

7. Procédé selon la revendication 1, dans lequel :
l'identification (203, 205, 207) de ii) comporte des opérations qui utilisent (205) un ensemble de systèmes d'apprentissage automatique configurés pour classer un document non structuré donné dans l'une parmi une pluralité prédéfinie de classes qui comportent une classe correspondant à des documents schématiques non structurés et une classe correspondant à des documents schématiques non structurés.

8. Procédé selon la revendication 7, dans lequel :
l'ensemble de systèmes d'apprentissage automatique comporte au moins un système d'apprentissage automatique configuré pour classer le document non structuré donné en fonction de caractéristiques textuelles du document non structuré donné et au moins un système d'apprentissage automatique configuré pour classer le document non structuré donné en fonction de caractéristiques visuelles du document non structuré donné.

9. Procédé selon la revendication 7, dans lequel :
l'ensemble de systèmes d'apprentissage automatique comprend au moins l'un parmi un système d'apprentissage automatique de forêt aléatoire et un système d'apprentissage automatique de réseau neuronal convolutif.

10. Procédé selon la revendication 1, dans lequel :
les opérations comportent i) des premières opérations qui appliquent des techniques de détection des bords de vision par ordinateur et/ou de recherche de contour au document non structuré donné afin de générer une disposition de squelette de table, ii) des deuxièmes opérations qui appliquent une reconnaissance optique de caractères à des boîtes englobantes dérivées de la disposition de squelette de table ; et iii) des troisièmes opérations qui fusionnent la disposition de squelette de table et les résultats de l'OCR pour générer le document schématique converti.

11. Procédé selon la revendication 1, dans lequel :
le dictionnaire de domaine est construit avec l'aide d'experts de domaine pour faciliter diverses tâches de traitement qui traduisent le texte du document schématique converti dans un format structuré et génèrent les données structurées sous forme électronique.

12. Procédé selon la revendication 1, dans lequel :
le moteur de traitement de langage naturel est configuré pour réaliser au moins une tâche de traitement sur du texte du document schématique converti, dans lequel l'au moins une tâche de traitement est choisie parmi le groupe segmentation de texte, balisage de partie de discours, classification de texte, mot-clé, extraction de concept, et des combinaisons de ceux-ci.
